(19) Europäisches Patentamt
European Patent Office
Office européen des brevets

(11) **EP 2 940 870 B1**

(12) **EUROPÄISCHE PATENTSCHRIFT**

(45) Veröffentlichungstag und Bekanntmachung des Hinweises auf die Patenterteilung:
**05.06.2019 Patentblatt 2019/23**

(51) Int Cl.:
*H03K 19/003* (2006.01)    *H04B 7/185* (2006.01)

(21) Anmeldenummer: **15000985.0**

(22) Anmeldetag: **07.04.2015**

(54) **REDUNDANZKONZEPT FÜR ANALOGE SCHALTUNGEN UND FUNKTIONEN ZUR STÖRUNGSUNTERDRÜCKUNG**

REDUNDANCY CONCEPT FOR ANALOG CIRCUITS AND FUNCTIONS FOR INTERFERENCE SUPPRESSION

CONCEPT DE REDONDANCE POUR COMMUTATEURS ET FONCTIONS ANALOGIQUES DESTINÉS À LA SUPPRESSION DES PERTURBATIONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.04.2014 DE 102014006229**

(43) Veröffentlichungstag der Anmeldung:
**04.11.2015 Patentblatt 2015/45**

(73) Patentinhaber: **Tesat-Spacecom GmbH & Co. KG 71522 Backnang (DE)**

(72) Erfinder: **Lück, Volker 71549 Auenwald (DE)**

(74) Vertreter: **LKGLOBAL Lorenz & Kopf PartG mbB Patentanwälte et al Brienner Straße 11 80333 München (DE)**

(56) Entgegenhaltungen:
**DE-A1- 1 431 149     US-A1- 2002 101 269 US-A1- 2007 205 799**

**Beschreibung**

Gebiet der Erfindung

Die Erfindung betrifft eine Störungsunterdrückungsschaltung zum Bereitstellen eines störungsreduzierten Signals basierend auf einer Mehrzahl von redundanten Funktionsblöcken sowie ein Raumfahrzeug mit einer solchen Störungsunterdrückungsschaltung, insbesondere einen Satelliten mit einer solchen Störungsunterdrückungsschaltung.

Technischer Hintergrund

Insbesondere beim Einsatz von elektrischen Schaltungen in strahlungsbelasteten Umgebungen, beispielsweise im Weltraum am Rande der Erdatmosphäre oder außerhalb der Atmosphäre im Vakuum, kann es bedingt durch Strahlung zu Störeffekten in elektronischen Bauteilen kommen, so dass in Folge solcher Störungen der einzelnen elektrischen Bauteile die Arbeitsweise einer elektrischen Schaltungen insgesamt gestört wird.

Ein üblicher Mechanismus zur Eliminierung solcher Störungen im Bereich von Digitalschaltungen ist eine Redundanz auf Grund einer Mehrheitsentscheidung. Dabei werden mehrere gleichartige Funktionsblöcke zur Durchführung einer Funktion verwendet und die jeweiligen Ausgangssignale dieser Funktionsblöcke werden einem Mehrheitsentscheid zugeführt, d.h. dass aus den ggf. voneinander abweichenden Ausgangssignalen der Funktionsblöcke dasjenige Ausgangssignal für die weitere Verarbeitung gewählt wird, welches von den meisten Funktionsblöcken ausgegeben wurde.

Bei Analogschaltungen ist ein solcher Mechanismus nicht möglich, da wertekontinuierliche Signale verarbeitet werden. Ein Mehrheitsentscheid ist somit praktisch nicht möglich, da auf Grund der wertekontinuierlichen Signale schon geringste Abweichungen zwischen zwei Ausgangssignalen einen Mehrheitsentscheid nicht zulassen.

Bekannte Ansätze zur Reduzierung von strahlungsbedingten Störeffekten bei Analogschaltungen sind Mittelwertbildung aus den Ausgangssignalen mehrerer redundanter Funktionsblöcke oder die Auswahl eines mittleren Wertes aus der sortierten Menge aller Ausgangssignale.

US 2007/0109012 A1 beschreibt einen Schaltungsaufbau zur Reduzierung von Störeffekten in redundanten Funktionsblöcken unter Verwendung von Komparatoren und Sortierung.

DE 14 31 149 beschreibt eine Redundanz-Einrichtung für Flugzeuge mit einer Anzahl von Funktionselementen, die mehrfach vorhanden sind und in solcher Weise nachgebildet sind, dass eine entsprechende Anzahl von Ausgangsleistungen vorhanden ist. Ein Selektionsgatter verbindet die Ausgangsleistungen zur Selektion eines Signals mittlerer Amplitude aus mehreren Eingangssignalen.

US 2002/101269 A1 beschreibt eine Halbleiterschaltung zum Handhaben von singulären Fehlern.

US 2007/205799 A1 beschreibt den Aufbau einer logischen Schaltung, welche für den Einsatz im Weltraum vorgesehen ist.

Zusammenfassung der Erfindung

Es kann als Aufgabe der Erfindung betrachtet werden, eine Störungsunterdrückungsschaltung bereitzustellen, welche in einer strahlungsbelasteten Umgebung eine Genauigkeit eines durch diese Schaltung ermittelten störungsreduzierten Signals erhöht.

Gemäß der Erfindung ist eine Störungsunterdrückungsschaltung zum Bereitstellen eines störungsreduzierten Signals angegeben. Die Störungsunterdrückungsschaltung weist auf: eine Mehrzahl von redundanten Funktionsblöcken, welche ausgeführt sind, jeweils ein Ausgangssignal bereitzustellen; eine erste Extremwertermittlungseinheit, welche ausgeführt ist, aus den Ausgangssignalen der Funktionsblöcke zumindest einen Extremwert zu ermitteln, wobei es sich bei dem Extremwert um einen Maximalwert der Ausgangssignale oder um einen Minimalwert der Ausgangssignale handelt; eine Verarbeitungseinheit, welche als Summierwerk ausgeführt ist, wobei das Summierwerk ausgeführt ist, ein Signal als Summe aller Ausgangssignale zu ermitteln, den zumindest einen Extremwert hiervon zu subtrahieren, und das störungsreduzierte Signal als Resultat dieser Subtraktion auszugeben.

Bei der Mittelwertbildung wird der Einfluss einer Störung lediglich reduziert, unter keinen Umständen aber eliminiert. Je mehr redundante Funktionsblöcke verwendet werden, desto geringer ist der Einfluss des Ausgangssignals eines störungsbehafteten Funktionsblocks auf das über alle Ausgangssignale gemittelte Signal.

Wird hingegen zwischen mehreren Ausgangssignalen redundanter Funktionsblöcke umgeschaltet, beispielsweise um zu jedem Zeitpunkt das mittlere Signal aller Ausgangssignale der Funktionsblöcke bereitzustellen, ist dazu ein Komparator notwendig, der jeweils zwei oder mehrere Ausgangssignale miteinander vergleicht. Ein solcher Komparator kann jedoch unter dem Einfluss von Strahlung auch störungsanfällig sein, so dass die Zuverlässigkeit des ermittelten Signals auch hierbei gering sein kann.

Zusätzlich kann es beim Anliegen zwei gleicher Signale am Komparator zu störenden, ungewollten und unnötigen Schaltvorgängen kommen.

Unter Strahlung im Zusammenhang mit dieser Anmeldung wird energetische Strahlung verstanden, welche ein elektrisches Bauteil in seiner Arbeits- und Funktionsweise beeinflussen kann. Energetische Strahlung ist beispielsweise hochenergetische kosmische Teilchenstrahlung bestehend aus Protonen, Elektronen und/oder ionisierten Atomen, Gammastrahlung oder Röntgenstrahlung.

Gemäß einem ersten Aspekt ist eine Störungsunterdrückungsschaltung zum Bereitstellen eines störungsreduzierten Signals angegeben. Die Störungsunterdrückungsschaltung weist eine Mehrzahl von redundanten Funktionsblöcken auf, welche ausgeführt sind, jeweils ein Ausgangssignal bereitzustellen. Weiterhin weist die Störungsunterdrückungsschaltung eine erste Extremwertermittlungseinheit auf, welche ausgeführt ist, aus den Ausgangssignalen der Funktionsblöcke dasjenige Ausgangssignal zu ermitteln, welches einen ersten Extremwert darstellt. Weiterhin weist die Störungsunterdrückungsschaltung eine Verarbeitungseinheit auf, welche ausgeführt ist, die Ausgangssignale der Mehrzahl von Funktionsblöcken so miteinander zu verrechnen, dass das störungsreduzierte Signal ermittelt wird.

Dabei ist die Verarbeitungseinheit ausgeführt, bei der Ermittlung des störungsreduzierten Signals den ersten Extremwert unberücksichtigt zu lassen.

Die Störungsunterdrückungsschaltung ermöglicht insbesondere, dass der Einfluss eines Ausgangssignals eines gestörten Funktionsblocks auf das störungsreduzierte Signal minimiert oder eliminiert wird.

Die Funktionsblöcke sind ausgeführt, die gleiche Operation redundant auszuführen. Es kann sich hierbei um sicherheitsrelevante Berechnungen handeln, oder beispielsweise um Navigationsdaten eines Luft- oder Raumfahrzeugs oder andere Berechnungen in Bordsystemen hiervon oder in Instrumenten an Bord von Luft- oder Raumfahrzeugen. Bei den Funktionsblöcken kann es sich insbesondere um analoge Funktionsblöcke handeln, d.h. dass das Ausgangssignal ein wertekontinuierliches und/oder zeitkontinuierliches Signal darstellt. Insbesondere kann es sich bei den Funktionsblöcken um strahlungsempfindliche Funktionsblöcke handeln.

Das störungsreduzierte Signal wird ohne das den Extremwert darstellende Ausgangssignal ermittelt. Unter der Annahme, dass eine strahlungsbedingte Störung eines elektrischen Bauteils oder eines Funktionsblocks zu einem fehlerhaften Ausgangssignal führt, welches von den korrekt ermittelten Ausgangssignalen der Funktionsblöcken abweicht, kann die Störungsunterdrückungsschaltung den Einfluss dieses gestörten Ausgangssignals auf die Ermittlung des störungsreduzierten Signals eliminieren, soweit es sich bei dem gestörten Ausgangssignal eben um das Ausgangssignal handelt, welches den Extremwert in der Menge der Ausgangssignale darstellt.

Das störungsreduzierte Signal wird ohne Verwendung von störungsanfälligen Komparatoren oder Umschaltvorgänge ermittelt.

Die Verarbeitungseinheit ermittelt aus der Gesamtzahl der Ausgangssignale der Funktionsblöcke sowie unter Berücksichtigung der durch die Extremwertermittlungseinheiten ermittelten Extremwerte ein einzelnes störungsreduziertes Signal. Dies erfolgt erfindungsgemäß durch Summenbildung, wobei die einzelnen Ausgangssignale unmittelbar zur Summenbildung herangezogen werden und die Extremwerte von der Summe über alle Ausgangssignale subtrahiert werden. Alternativ können die Ausgangssignale mit einem Faktor oder miteinander multipliziert werden, bevor das störungsreduzierte Signal entsprechend ermittelt wird.

Gemäß einer Ausführungsform ist die erste Extremwertermittlungseinheit ausgeführt, einen Maximalwert der Ausgangssignale der Funktionsblöcke zu ermitteln, so dass der erste Extremwert dem Maximalwert der Ausgangssignale der Funktionsblöcke entspricht.

Gemäß einer weiteren Ausführungsform weist die Störungsunterdrückungsschaltung eine zweite Extremwertermittlungseinheit auf, welche ausgeführt ist, einen zweiten Extremwert der Ausgangssignale der Funktionsblöcke zu ermittelt. Der zweite Extremwert entspricht einem Minimalwert der Ausgangssignale der Funktionsblöcke.

Damit kann der Fall berücksichtigt werden, dass eine Störung eines Funktionsblocks sich positiv oder negativ auf das Ausgangssignal auswirkt. Da die tatsächliche Auswirkung einer Störung im Vorfeld in vielen Fällen unbekannt ist, kann somit eine Abweichung eines Ausgangssignals nach oben oder nach unten von den Ausgangssignalen der anderen Funktionsblöcken bei der Ermittlung des störungsreduzierten Signals abgefangen werden, d.h. dass eine Störung unabhängig von ihrer Wirkungsrichtung auf die Abweichung eines Ausgangssignals für die Ermittlung des störungsreduzierten Signals unberücksichtigt bleibt.

In anderen Worten werden somit ein Maximalwert (positiver Extremwert) und ein Minimalwert (negativer Extremwert) bei der Ermittlung des störungsreduzierten Signals nicht berücksichtigt.

In einer weiteren Ausführungsform können auch mehr als ein positiver Extremwert (beispielsweise die beiden höchsten Werte) und mehr als ein negativer Extremwert (beispielsweise die beiden niedrigsten Werte) bei der Ermittlung des störungsreduzierten Signals unberücksichtigt bleiben, beispielsweise wenn mit mehr als einem bzw. zwei gestörten Funktionsblöcken gerechnet wird. Jedoch gilt, dass der Aufwand zur Ermittlung zusätzlicher Höchst- oder Niedrigstwerte ansteigt und die Störungsunterdrückungsschaltung damit an Komplexität zunehmen kann sowie die Dauer zur Ermittlung des störungsreduzierten Signals ansteigen kann.

Gemäß einem Beispiel ist die Verarbeitungseinheit ausgeführt, bei der Ermittlung des störungsreduzierten Signals zumindest einen Extremwert unberücksichtigt zu lassen.

Hierbei kann es sich um den Maximalwert oder um den Minimalwert handeln. Wenn beispielsweise die Wirkungsrichtung einer Störung bekannt ist, kann die Verarbeitungseinheit darauf beschränkt werden, den Maximalwert oder den Minimalwert nicht zu berücksichtigen, was die Arbeitsweise der Störungsunterdrückungsschaltung vereinfachen kann oder beispielsweise die Rechenzeit der Verarbeitungseinheit reduzieren kann.

Gemäß einem Beispiel ist die Verarbeitungseinheit ausgeführt, bei der Ermittlung des störungsreduzierten Signals den ersten Extremwert und den zweiten Extremwert unberücksichtigt zu lassen.

Dies erfordert keine Fallunterscheidung betreffend die Wirkungsrichtung der Störeffekte und kann somit die Verwendung der Störungsunterdrückungsschaltung in Umgebungen mit wechselnden Störungseinflüssen verbessern.

Gemäß der Erfindung ist die Verarbeitungseinheit als Summierwerk ausgeführt. Das Summierwerk ist beispielsweise ausgeführt, das störungsreduzierte Signal als Summe der Ausgangssignale der Funktionsblöcke zu ermitteln und bei der Ermittlung dieser Summe einen der beiden Extremwerte unberücksichtigt zu lassen.

Gemäß einem Beispiel ist das Summierwerk ausgeführt, das störungsreduzierte Signal als Summe der Ausgangssignale der Funktionsblöcke zu ermitteln und bei der Ermittlung dieser Summe den ersten Extremwert und den zweiten Extremwert unberücksichtigt zu lassen.

Erfindungsgemäß ist das Summierwerk ausgeführt, das störungsreduzierte Signal als Summe aller Ausgangssignale zu ermitteln und einen Extremwert hiervon zu subtrahieren, bevor das störungsreduzierte Signal bereitgestellt wird. In anderen Worten wird also auch das Ausgangssignal für die Summenbildung herangezogen, welches einen Extremwert darstellt, bevor anschließend der Extremwert wieder von der Summe abgezogen wird.

In dieser Ausführungsform kann das Summierwerk einen einfachen Aufbau aufweisen, da unabhängig davon, welcher Funktionsblock den Extremwert liefert, zunächst alle Ausgangssignale einem Addierer zugeführt werden. Eine Zuführung des Extremwerts zur Subtraktion von der Summe erfolgt dann abhängig davon, welches Ausgangssignal tatsächlich den Extremwert darstellt.

Alternativ kann das Summierwerk so aufgebaut sein, dass der Extremwert der Summenbildung gar nicht erst zugeführt wird, also schon bei der Summenbildung unberücksichtigt bleibt.

Im Ergebnis wirken sich diese beiden Varianten nicht auf den Wert des störungsreduzierten Signals aus, sondern lediglich auf die Art und Weise der Ermittlung des störungsreduzierten Signals.

Gemäß einer weiteren Ausführungsform weist die Störungsunterdrückungsschaltung drei oder mehr Funktionsblöcke auf.

Diese Anzahl von Funktionsblöcken ermöglicht die Nichtberücksichtigung des Minimal- und des Maximalwertes, wobei dann für die Ermittlung des störungsreduzierten Signals noch ein einzelnes Ausgangssignal eines Funktionsblocks übrig bleibt, nämlich das Ausgangssignal mit dem mittleren Wert.

Jeder weitere Funktionsblock, um den die Anzahl der Funktionsblöcke die Zahl drei übersteigt, trägt zur Redundanz für die Ermittlung des störungsreduzierten Signals bei, für den Fall, dass die Ausgangssignale von zwei Funktionsblöcken (Minimalwert und Maximalwert) unberücksichtigt sind.

Gemäß einer weiteren Ausführungsform weist die Störungsunterdrückungsschaltung eine Mittelwertbildungseinheit auf, welche ausgeführt ist, aus dem störungsreduzierten Signal ein gemitteltes Signal zu bilden.

Gemäß einer weiteren Ausführungsform ist die Mittelwertbildungseinheit ausgeführt, das gemittelte Signal mittels Division des störungsreduzierten Signals durch die Anzahl der Funktionsblöcke abzüglich der unberücksichtigten Extremwerte bei der Ermittlung des störungsreduzierten Signals zu bilden.

Die Mittelwertbildungseinheit kann mit der Verarbeitungseinheit so gekoppelt sein, dass die Anzahl der Extremwerte, welche für die Ermittlung des störungsreduzierten Signals unberücksichtigt bleiben, an die Mittelwertbildungseinheit übertragen werden, so dass der Mittelwert basierend auf der korrekten Anzahl berücksichtigter Ausgangssignale erfolgt.

Im Fall von acht Funktionsblöcken und der Nichtberücksichtigung von Minimalwert und Maximalwert der Ausgangssignale der Funktionsblöcke werden für die Ermittlung des störungsreduzierten Signals sechs Ausgangssignale berücksichtigt. Im Fall der Summenbildung kann diese entweder über alle acht Ausgangssignale gebildet werden unter anschließender Subtraktion von Minimalwert und Maximalwert von dieser Summe oder die beiden Extremwerte werden für die Summenbildung gar nicht berücksichtigt. Für die Mittelwertbildung wird das störungsreduzierte Signal durch sechs dividiert, da das störungsreduzierte Signal auch nur basierend auf sechs Ausgangssignalen ermittelt wurde.

Allgemein kann dieser Zusammenhang so ausgedrückt werden:

gemitteltes Signal = (Summe aller Ausgangssignale – Maximalwert – Minimalwert) / (Anzahl der Funktionsblöcke – 2)

Die Störungsunterdrückungsschaltung wie oben und im Folgenden beschrieben kann in jeder Schaltung angewandt werden, die empfindlich gegenüber Strahlung ist und strahlungsbedingte Transienten erzeugt. Die Störungsunterdrückungsschaltung ist in Halbleiterschaltungen integrierbar.

Gemäß einem weiteren Aspekt ist ein Raumfahrzeug mit einer Störungsunterdrückungsschaltung wie oben und im Folgenden beschrieben angegeben.

Gemäß einer Ausführungsform handelt es sich bei dem Raumfahrzeug um einen Satelliten.

Ferner sei angemerkt, dass das erfinderische Konzept beispielsweise auch im Hochgebirge (erhöhte kosmische Strahlung) oder im Bereich von Kernforschungsanlagen zur Anwendung kommen kann.

Nachfolgend wird anhand der beigefügten Zeichnungen näher auf Ausführungsbeispiele der Erfindung eingegangen. Es zeigen:

**Fig. 1**     eine schematische Darstellung einer Störungsunterdrückungsschaltung gemäß einem Ausführungsbeispiel.

**Fig. 2**     eine schematische Darstellung einer Störungsunterdrückungsschaltung gemäß einem weiteren Ausführungsbeispiel.

Detaillierte Beschreibung von Ausführungsbeispielen

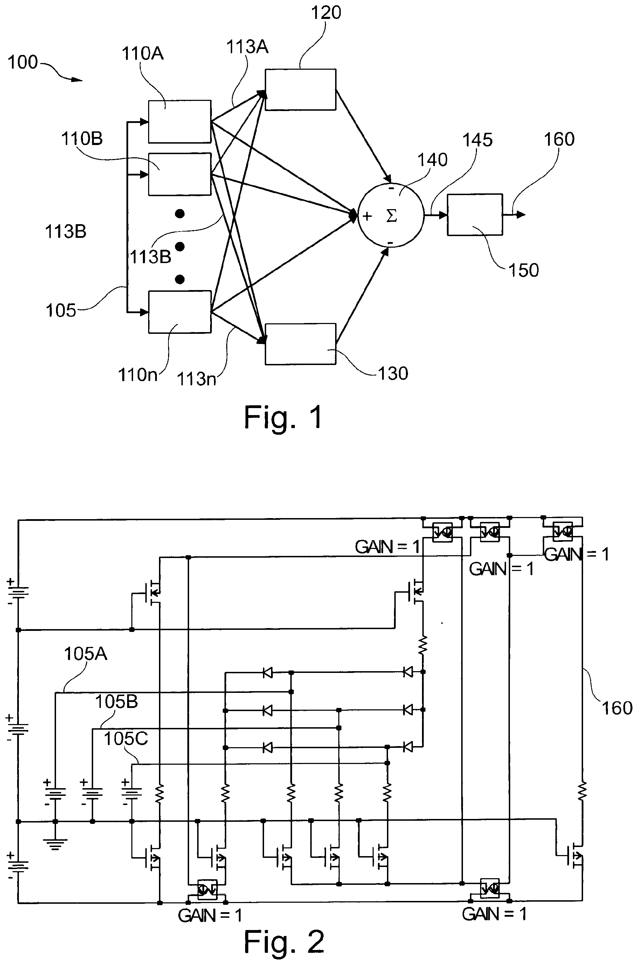

Fig. 1 zeigt eine Störungsunterdrückungsschaltung 100 mit einer Mehrzahl von redundanten Funktionsblöcken 110A, 110B, 110n. Die Funktionsblöcke werden jeweils mit einem Eingangssignal 105 versorgt. Die Eingangssignale der Funktionsblöcke können Daten oder Werte sein, welche identisch sind, wie auch die von den Funktionsblöcken durchgeführten Operationen.

Jeder Funktionsblock ermittelt basierend auf den Eingangssignal 105 ein eigenes Ausgangssignal 113A, 113B, 113n. Alle Ausgangssignale 113A, 113B, 113n werden sowohl an die erste Extremwertermittlungseinheit 120, an die zweite Extremwertermittlungseinheit 130 sowie an die Verarbeitungseinheit 140 übermittelt.

Die erste Extremwertermittlungseinheit 120 ermittelt den Maximalwert und die zweite Extremwertermittlungseinheit 130 den Minimalwert der Ausgangssignale.

Die Verarbeitungseinheit 140 ist als Summierwerk oder Addierer ausgeführt und ermittelt die Summe über alle Ausgangssignale 113A, 113B, 113n.

Bevor die Verarbeitungseinheit 140 das störungsreduzierte Signal 145 ausgibt, werden der Maximalwert und der Minimalwert von der Summe über alle Ausgangssignale subtrahiert.

Das störungsreduzierte Signal 145 wird einer Mittelwertbildungseinheit 150 zugeführt, welche hieraus das gemittelte Signal 160 bildet.

Fig. 2 zeigt eine beispielhafte Implementierung der Funktionen der Summation und der Extremwertbestimmung.

In diesem Beispiel wird für die Summenbildung die Addition von Strömen, für die Extremwertbestimmung die Verknüpfung über Dioden gezeigt. Die Mittelwertbildung kann durch Widerstandsverhältniswahl erfolgen.

Diese Implementierung zeichnet sich dadurch aus, dass die Extremwertbestimmung sehr schnell erfolgt und die insgesamt verwendeten Schaltungskonstrukte und elektrischen Bauteile selbst als strahlungsunempfindlich angesehen werden können. Auch die verwendeten Stromspiegel können als hinreichend schnell angesehen werden, um das quasi gleichzeitige Eintreffen aller Summanden, d.h. Ausgangssignale der Funktionsblöcke, an dem Summationspunkt, d.h. an der Verarbeitungseinheit, was zum Eliminieren der Störung beiträgt, annehmen zu dürfen.

In Fig. 2 sind die Funktionsblöcke beispielhaft als drei Spannungsquellen dargestellt, so dass der Spannungswert sowohl dem Eingangssignal 105A, 105B, 105C als auch dem Ausgangssignal der Funktionsblöcke entspricht, da hier keine Verarbeitung des Eingangssignals in den Funktionsblöcken erfolgt.

**Patentansprüche**

1.    Störungsunterdrückungsschaltung (100) zum Bereitstellen eines störungsreduzierten Signals (145), aufweisend:

eine Mehrzahl von redundanten Funktionsblöcken (110A, 110B, 110n), welche ausgeführt sind, jeweils ein Ausgangssignal (113A, 113B, 113n) bereitzustellen;

eine Extremwertermittlungseinheit (120), welche ausgeführt ist, aus den Ausgangssignalen der Funktionsblöcke zumindest einen Extremwert zu ermitteln, wobei es sich bei dem Extremwert um einen Maximalwert der Ausgangssignale oder um einen Minimalwert der Ausgangssignale handelt;

eine Verarbeitungseinheit (140), welche als Summierwerk ausgeführt ist;

wobei das Summierwerk ausgeführt ist, ein Signal als Summe aller Ausgangssignale zu ermitteln, den zumindest einen Extremwert hiervon zu subtrahieren, und das störungsreduzierte Signal als Resultat dieser Subtraktion auszugeben.

2.    Störungsunterdrückungsschaltung (100) nach Anspruch 1,

wobei die Verarbeitungseinheit ausgeführt ist, von der Summe aller Ausgangssignale einen ersten Extremwert, welcher ein Maximalwert der Ausgangssignale ist, und einen zweiten Extremwert, welcher ein Minimalwert der Ausgangssignale ist, zu subtrahieren, zur Ermittlung des störungsreduzierten Signals.

**3.** Störungsunterdrückungsschaltung (100) nach einem der vorhergehenden Ansprüche,
weiterhin aufweisend eine Mittelwertbildungseinheit (150), welche ausgeführt ist, aus dem störungsreduzierten Signal ein gemitteltes Signal (160) zu bilden.

**4.** Störungsunterdrückungsschaltung (100) nach Anspruch 3,
wobei die Mittelwertbildungseinheit (150) ausgeführt ist, das gemittelte Signal (160) mittels Division des störungsreduzierten Signals (145) durch die Anzahl der Funktionsblöcke abzüglich der Anzahl der subtrahierten Extremwerte zu bilden.

**5.** Raumfahrzeug mit einer Störungsunterdrückungsschaltung nach einem der vorhergehenden Ansprüche.

**6.** Raumfahrzeug nach Anspruch 5,
wobei das Raumfahrzeug ein Satellit ist.

## Claims

**1.** Interference suppression circuit (100) for providing a reduced-interference signal (145), having:

a plurality of redundant functional blocks (110A, 110B, 110n) which are each designed to provide an output signal (113A, 113B, 113n);
an extreme value determination unit (120) which is designed to determine at least one extreme value from the output signals from the functional blocks, wherein the extreme value is a maximum value of the output signals or a minimum value of the output signals;
a processing unit (140) which is in the form of a summation unit;
wherein the summation unit is designed to determine a signal as the sum of all output signals, to subtract the at least one extreme value therefrom and to output the reduced-interference signal as the result of this subtraction.

**2.** Interference suppression circuit (100) according to Claim 1,
wherein the processing unit is designed to subtract a first extreme value, which is a maximum value of the output signals, and a second extreme value, which is a minimum value of the output signals, from the sum of all output signals in order to determine the reduced-interference signal.

**3.** Interference suppression circuit (100) according to one of the preceding claims,
also having an averaging unit (150) which is designed to form an averaged signal (160) from the reduced-interference signal.

**4.** Interference suppression circuit (100) according to Claim 3,
wherein the averaging unit (150) is designed to form the averaged signal (160) by dividing the reduced-interference signal (145) by the number of functional blocks minus the number of subtracted extreme values.

**5.** Spacecraft having an interference suppression circuit according to one of the preceding claims.

**6.** Spacecraft according to Claim 5,
wherein the spacecraft is a satellite.

## Revendications

**1.** Circuit de suppression du brouillage (100) destiné à fournir un signal à brouillage réduit (145), comprenant :

une pluralité de blocs fonctionnels redondants (110A, 110B, 110n) qui sont respectivement conçus pour fournir un signal de sortie (113A, 113B, 113n) ;
une unité de détermination de valeur extrême (120) qui est conçue pour déterminer au moins une valeur extrême

**EP 2 940 870 B1**

à partir des signaux de sortie des blocs fonctionnels, dans lequel la valeur extrême est une valeur maximale des signaux de sortie ou une valeur minimale des signaux de sortie ;
une unité de traitement (140) qui est réalisée sous la forme d'un mécanisme de sommation ;
dans lequel le mécanisme de sommation est conçu pour déterminer un signal comme étant la somme de tous les signaux de sortie, pour y soustraire ladite au moins une valeur extrême, et pour délivrer le signal à brouillage réduit en tant que résultat de ladite soustraction.

2. Circuit de suppression du brouillage (100) selon la revendication 1,
dans lequel l'unité de traitement est conçue pour soustraire à la somme de tous les signaux de sortie une première valeur extrême, qui est une valeur maximale des signaux de sortie, et une seconde valeur extrême, qui est une valeur minimale des signaux de sortie, afin de déterminer le signal à brouillage réduit.

3. Circuit de suppression du brouillage (100) selon l'une des revendications précédentes,
comprenant en outre une unité de calcul de moyenne (150) qui est conçue pour générer un signal moyenné (160) à partir du signal à brouillage réduit.

4. Circuit de suppression du brouillage (100) selon la revendication 3,
dans lequel l'unité de calcul de moyenne (150) est conçue pour calculer le signal moyenné (160) en divisant le signal à brouillage réduit (145) par le nombre des blocs fonctionnels moins le nombre des valeurs extrêmes soustraites.

5. Véhicule spatial comportant un circuit de suppression du brouillage selon l'une des revendications précédentes.

6. Véhicule spatial selon la revendication 5, dans lequel le véhicule spatial est un satellite.

7

Fig. 1

Fig. 2

**EP 2 940 870 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070109012 A1
- DE 1431149
- US 2002101269 A1
- US 2007205799 A1